# EUROPEAN PATENT APPLICATION

(11) **EP 3 780 096 A1**
(43) Date of publication of application: **17.02.2021**
(21) Application number: 19919569.4
(22) Date of filing: 13.05.2019
(51) Int. Cl.: H01L 23/552, H01L 23/367, H01L 25/065

(54) **SUBSTRATE STRUCTURE AND CONTROL METHOD THEREFOR**

(30) Priority: 29.03.2019 KR 20190036898
(71) Applicant: LG Electronics Inc., Seoul 07336 (KR)
(72) Inventor: KIM, Jongwon, Seocho-Gu, Seoul 06772 (KR); YOON, Yeojun, Seocho-Gu, Seoul 06772 (KR)
(74) Representative: Vossius & Partner Patentanwälte Rechtsanwälte mbB
(86) International application number: PCT/KR2019/005716
(87) International publication number: WO 2020/204252

(57) **Abstract**

The present disclosure relates to a substrate structure, including a substrate including at least one electronic device, a first SMD gasket configured to remove an electromagnetic wave formed on the substrate and radiated from the substrate, a second SMD gasket configured to remove an electromagnetic wave formed on the substrate and radiated from the substrate, and a cover shield installed on a surface confronting the substrate to externally discharge heat within the installed region. Here, if a frequency generated from the electronic device is a specific frequency, a spaced distance between the first SMD gasket and the second SMD gasket is set to a length different from a prescribed magnification of a wavelength corresponding to the specific frequency.

## Description

### TECHNICAL FIELD

The present disclosure relates to a substrate structure and method for controlling the same, suitable for improving electromagnetic interference caused by a signal having high frequency characteristic in a manner of adjusting a distance between SMD gaskets.

### BACKGROUND ART

Reducing electromagnetic interference has become an important topic in the industry due to changes in mobile devices and the introduction of various digital technologies such as digital home appliances, Internet Of Things (IOT), fingerprint recognition, FinTech, etc.

The downsizing of IT devices and the multi-functionalization of automotive electronic devices have resulted in high-density mounting and increased operating frequencies in the high frequency band (1 ~ 10 GHz), resulting in electromagnetic interference, noise-induced malfunctions and signal quality degradation, thereby increasing the importance of Electro Magnetic Interference (EMI) shielding technology.

For electromagnetic interference shielding, a shield structure is formed using a cover shield for heat radiation. In case of high frequency, the shield structure forms a radial structure, making electromagnetic interference worse. Thus, it is often improved by adding an anti-electromagnetic interference taps or the like to reinforce the shielding structure, which causes a problem of additional cost.

### DETAILED DESCRIPTION OF DISCLOSURE

### TECHNICAL TASKS

One technical task of one embodiment of the present disclosure is to provide a substrate structure and method for controlling the same, which shields electromagnetic interference by adjusting a spaced distance between a first SMD gasket and a second SMD gasket if a size of a frequency generated from an electronic device is greater than that of a specific frequency.

Another technical task of one embodiment of the present disclosure is to provide a substrate structure and method for controlling the same, which shields electromagnetic interference by inserting a passive device between a first SMD gasket and a second SMD gasket if a size of a frequency generated from an electronic device is greater than that of a specific frequency.

Technical tasks obtainable from the present disclosure are non-limited by the above-mentioned technical task. And, other unmentioned technical tasks can be clearly understood from the following description by those having ordinary skill in the technical field to which the present disclosure pertains.

### TECHNICAL SOLUTIONS

In one technical aspect of the present disclosure, provided herein is a substrate structure including a substrate including at least one electronic device, a first SMD gasket configured to remove an electromagnetic wave formed on the substrate and radiated from the substrate, a second SMD gasket configured to remove an electromagnetic wave formed on the substrate and radiated from the substrate, and a cover shield installed on a surface confronting the substrate to externally discharge heat within the installed region, wherein if a frequency generated from the electronic device is a specific frequency, a spaced distance between the first SMD gasket and the second SMD gasket is set to a length different from a prescribed magnification of a wavelength corresponding to the specific frequency.

In another technical aspect of the present disclosure, provided herein is a method of controlling a substrate structure, the method including removing an electromagnetic wave formed on the substrate and radiated from the substrate through a first SMD gasket, removing an electromagnetic wave formed on the substrate and radiated from the substrate through a second SMD gasket, externally discharging heat within a region in which a cover shield is installed on a surface confronting the substrate, and if a frequency generated from the electronic device is a specific frequency, setting a spaced distance between the first SMD gasket and the second SMD gasket to a length different from a prescribed magnification of a wavelength corresponding to the specific frequency.

### ADVANTAGEOUS EFFECTS

According to one embodiment of the present disclosure, when a frequency generated from an electronic device is a specific frequency, electromagnetic interference may be cut off by adjusting a spaced distance in a manner that the spaced distance between a first SMD gasket and a second SMD gasket fails to correspond to a prescribed magnification of the specific frequency, thereby cutting off the electromagnetic interference without additionally reinforcing a shielding structure and also enhancing user convenience owing to cost reduction.

According to another embodiment of the present disclosure, when a frequency generated from an electronic device is greater than a specific frequency, electromagnetic interference may be cut off by inserting a passive device between a first SMD gasket and a second SMD gasket, thereby cutting off the electromagnetic interference without additionally reinforcing a shielding structure and also enhancing user convenience owing to cost reduction.

Effects obtainable from the present disclosure may be non-limited by the above-mentioned effect. And, other unmentioned effects can be clearly understood from the following description by those having ordinary skill in the technical field to which the present disclosure pertains.

### DESCRIPTION OF DRAWINGS

FIG. 1 is a diagram showing the configuration of a substrate structure according to one embodiment of the present disclosure.
FIG. 2 is a flowchart of a method of controlling a substrate structure according to one embodiment of the present disclosure.
FIG. 3 is a diagram showing a structure of a slot antenna according to one embodiment of the present disclosure.
FIG. 4 is a structural diagram of forming a slot antenna according to one embodiment of the present disclosure.
FIG. 5 is a diagram showing an example of electromagnetic interference occurrence attributed to a slot antenna structure according to one embodiment of the present disclosure.
FIG. 6 is a diagram showing an example before improving electromagnetic interference according to one embodiment of the present disclosure.
FIG. 7 is a diagram showing an SMD gasket land according to one embodiment of the present disclosure.
FIG. 8 is a diagram showing a gain reduction effect before and after inserting a passive device according to one embodiment of the present disclosure.
FIG. 9 is a diagram showing a structure of a passive device according to one embodiment of the present disclosure.
FIG. 10 is a diagram showing graphs before and after improving electromagnetic interference according to one embodiment of the present disclosure.
FIG. 11 is a diagram showing that an anti-electromagnetic interference tape is added to a substrate structure according to one embodiment of the present disclosure.

### BEST MODE FOR CARRYING OUT THE DISCLOSURE

Hereinbelow, embodiments of the present disclosure will be described in detail with reference to the accompanying drawings. Irrespective of figure numbers, the same or similar components are denoted by like reference numerals, and a redundant description of the components is avoided. In the following description, postfixes attached to the names of components, "module" and "unit" are assigned or interchangeably used only in consideration of ease of the description, and do not have differentiated meanings or functions.

Further, lest it should obscure the subject matter of the embodiments of the present disclosure, a related known technology is not described.

In addition, the accompanying drawings are given only to help with the understanding of the embodiments of the present disclosure, not limiting the technical spirit of the present disclosure, and it is to be understood that the disclosure covers all modifications, equivalents, and alternatives falling within the scope and spirit of the disclosure.

Terms including an ordinal number such as first or second may be used to describe various components, not limiting the components. The terms are used only for the purpose of distinguishing one component from another component.

When it is said that a component is "coupled with/to" or "connected to" another component, it should be understood that the one component is connected to the other component directly or through any other component. On the other hand, when it is said that a component is "directly coupled to" or "directly connected to" another component, it may be understood that there is no other component between the components.

Unless the context clearly dictates otherwise, singular forms include plural referents.

In the present disclosure, it is to be understood that the term "include" or "have" signifies the presence of a feature, a number, a step, an operation, a component, or a part, or a combination thereof as described in the disclosure, not excluding the presence or the possibility of addition of one or more other features, numbers, steps, components, or parts, or combinations thereof.

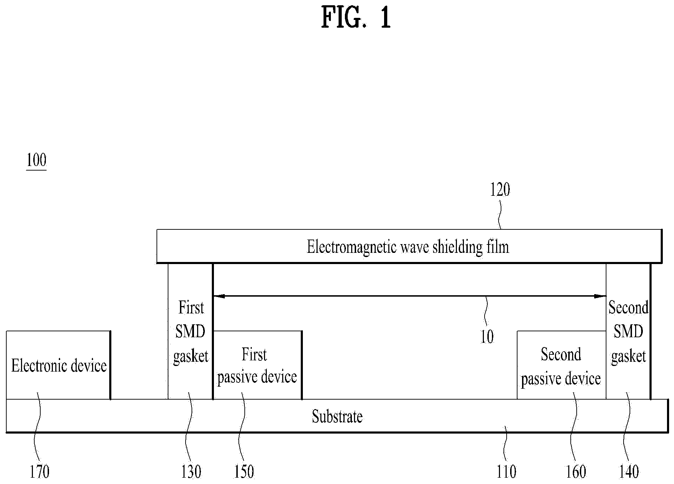

FIG. 1 is a diagram showing the configuration of a substrate structure according to one embodiment of the present disclosure.

Referring to FIG. 1, a substrate structure 100 includes a substrate 110, an electromagnetic wave shielding film 120, a first SMD gasket 130, a second SMD gasket 140, a first passive device 150, a second passive device 160 and an electronic device 170.

The substrate 110 includes at least one electronic device 170.

The cover shield 120 is installed on a face confronting the substrate so as to externally discharge heat inside region having the cover shield 120 installed thereon.

The first SMD gasket 130 is formed on the substrate 110 removing an electromagnetic wave formed on the substrate 110 and radiated from the substrate 110 and removes the electromagnetic wave radiated from the substrate 110. The Surface Mounted Devices (SMD) gasket is configured in a manner that a cushioned core is enclosed with a skin of conductive fiber, metal foil or the like and provided for the usage of grounding and shielding. Here, the SMD gasket is a countermeasure component for ElectroMagnetic Interference (EMI) that may occur from a Printed Circuit Board (PCB) or a Flexible Printed Circuit Board (FPCB) and is particularly used to effectively remove ElectroStatic Discharge (ESD) inside PCB/FPCB, ElectroMagnetic Interference (EMI), etc.

The second SMD gasket 140 is formed on the substrate 110 removing an electromagnetic wave formed on the substrate 110 and radiated from the substrate 110 and removes the electromagnetic wave radiated from the substrate 110.

The first SMD gasket 130 and the second SMD gasket 140 are connected to the substrate 110 in a grounded state.

Each of the first and second passive devices 150 and 160 is configured in a manner of combining a resistor, inductor and capacitor together in specific order.

For example, a passive device may be configured in a manner of configuring a first device by connecting a resistor and inductor together in series and connecting the first device and a second device corresponding to a capacitor in parallel with each other.

The electronic device 170 generates a frequency. The frequency generated from the electronic device 170 may become a DDR clock frequency. The electronic device 170 may become a CPU that generates a clock frequency.

For example, if the frequency generated from the electronic device 170 is a specific frequency, electromagnetic interference is cut off by adjusting a spaced distance 10 between the first SMD gasket and the second SMD gasket. In addition, when the frequency generated from the electronic device 170 is a specific frequency, electromagnetic interference is cut off by setting the spaced distance 10 between the first SMD gasket and the second SMD gasket to a length different from a prescribed magnification of a wavelength corresponding to the specific frequency.

For example, the spaced distance 10 may be adjusted so as to be different from the prescribed magnification of the wavelength corresponding to the specific frequency. Here, the prescribed magnification may include 1/16. Namely, if the spaced distance 10 becomes the prescribed magnification of the wavelength corresponding to the specific frequency, it works as an antenna that radiates the specific frequency, which corresponds to a case of the biggest electromagnetic interference.

For example, the spaced distance 10 may be set longer than the prescribed magnification of the wavelength corresponding to the specific frequency.

The substrate structure 100 may be installed inside a display device, a smart TV, a monitor, a projector, etc.

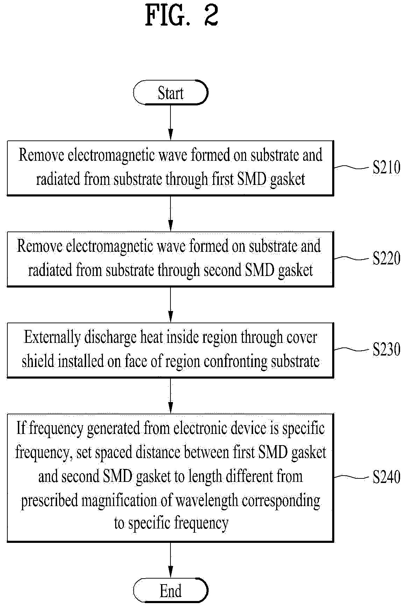

FIG. 2 is a flowchart of a method of controlling a substrate structure according to one embodiment of the present disclosure.

Referring to FIG. 2, an electromagnetic wave formed on the substrate and radiated from the substrate is removed through a first SMD gasket [S210].

An electromagnetic wave formed on the substrate and radiated from the substrate is removed through a second SMD gasket [S220].

A cover shield is installed on a face confronting the substrate and the heat inside the installed region is discharged through the cover shield [S230]. For example, the cover shield may use a heat sink made of aluminum material for in-product heat radiation.

In case that a frequency generated from an electronic device is a specific frequency, a spaced distance between the first and second SMD gaskets is set to a length different from a prescribed magnification of a wavelength corresponding to the specific frequency [S240].

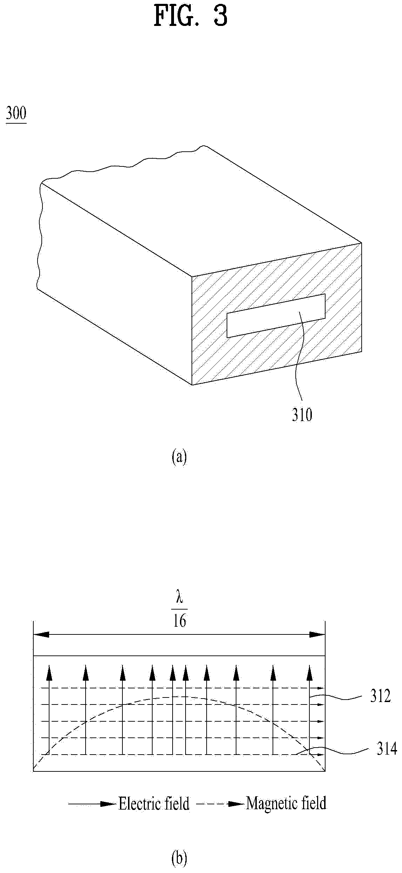

FIG. 3 is a diagram showing a structure of a slot antenna according to one embodiment of the present disclosure. FIG. 3 includes FIG. 3 (a) and FIG. 3 (b).

FIG. 3 (a) is a diagram showing a structure of a slot antenna. Referring to FIG. 3 (a), a slot antenna is configured by forming a slot 310 of various types in a lateral side of a waveguide. As the slot antenna can handle large power, it is popularly used for ships. The slot antenna may create various characteristics like an array antenna by adjusting various variables such as a slot, the number of slots, a slot shape, a slot distance, etc.

FIG. 3 (b) is a diagram showing a moving direction of electric and magnetic fields of a slot antenna.

An electric field 312 moves from a bottom side toward a top side, and a magnetic field 314 moves from a left side toward a right side. The electric field and the magnetic field interworks with each other. If the electric field is weakened, the magnetic field can be weakened as well.

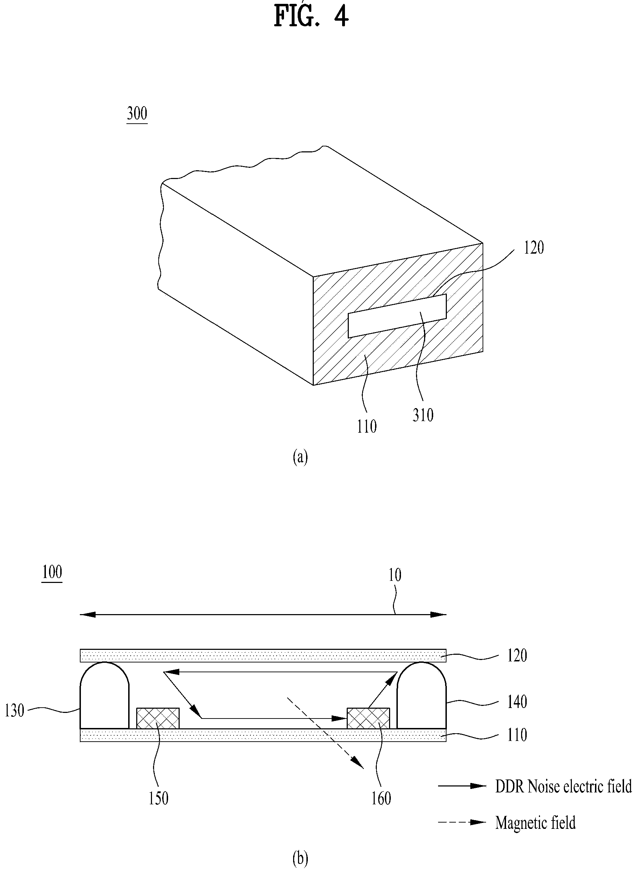

FIG. 4 is a structural diagram of forming a slot antenna according to one embodiment of the present disclosure. FIG. 4 includes FIG. 4 (a) and FIG. 4 (b).

FIG. 4 (a) is a diagram showing a substrate structure corresponding to a structure of a slot antenna. Referring to FIG. 4 (a), a substrate 110 and cover shield 120 of a substrate structure 100 correspond to a top and bottom of a slot 310 of a slot antenna 300, respectively.

FIG. 4 (b) is a diagram showing a case that a substrate structure becomes a slot antenna structure. Referring to FIG. 4 (b), a substrate structure 100 physically becomes a structure of a slot antenna 300. The substrate structure 100 includes a substrate 110, a cover shield 120, a first SMD gasket 130, a second SMD gasket 140, a first passive device 150 and a second passive device 160.

A distance between the first SMD gasket 130 and the second SMD gasket 140 becomes a spaced distance 10.

Each of the first and second passive devices 150 and 160 includes a least one resistor, inductor and capacitor.

In this case, DDR noise forms an electric field within the substrate structure 100 and a magnetic field is radiated by the electric field, whereby electromagnetic interference occurs.

According to the preset disclosure, the cover shield 120 is used for in-product heat radiation. For example, the cover shield 120 may include a heat sink of aluminum material. Yet, since the heat sink is a conductor of metal material, radiation is generated from resonance by the relation to a frequency of an electronic device, whereby electromagnetic interference occurs.

As shown in FIG. 4 (b), in case that a substrate structure forms a slot antenna structure, a size of electromagnetic energy within the substrate structure may increase more.

Hence, in order to decrease the size of the electromagnetic energy within the substrate structure 100, the first and second SMD gaskets 150 and 160 are connected to the substrate 110 by being grounded. At least one passive device is inserted between the first and second SMD gaskets 150 and 160.

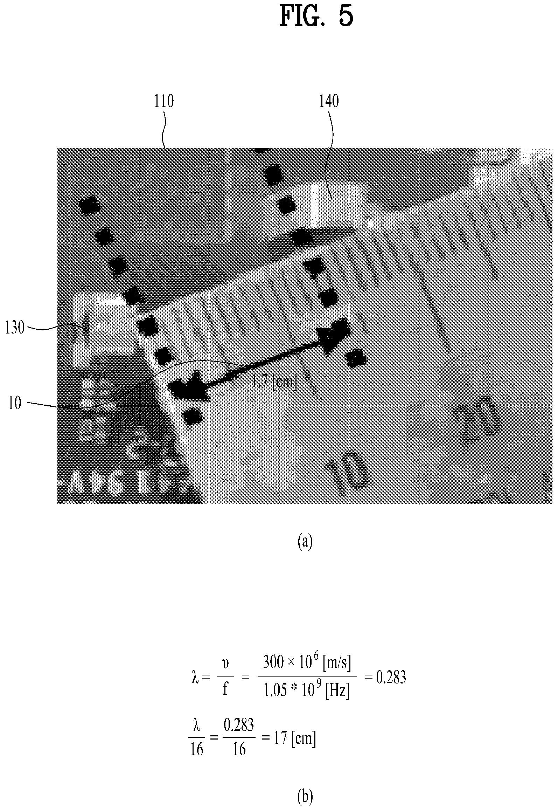

FIG. 5 is a diagram showing an example of electromagnetic interference occurrence attributed to a slot antenna structure according to one embodiment of the present disclosure. FIG. 5 includes FIG. 5 (a) and FIG. 5 (b).

FIG. 5 (a) is a diagram showing an embodiment that electromagnetic interference occurs due to a slot antenna structure. Referring to Fig. 5 (a), a substrate 110 includes a first SMD gasket 130 and a second SMD gasket 140. A spaced distance 10 means a distance between the first and second SMD gaskets 130 and 140. If the spaced distance 10 is 1.7 cm, an energy size of an electromagnetic wave is maximized.

FIG. 5 (b) shows equations to describe how a spaced distance is determined. Referring to FIG. 5 (b), a speed of an electromagnetic wave is 300,000 km/s. here, a frequency of an electronic device 170 is 1.05 GHz. A length of a wavelength results from dividing the speed of the electromagnetic wave by the frequency. Hence, the length of the wavelength becomes 0.283 m. If the length of the wavelength is divided by 16, it results in about 1.7 cm.

According to the present disclosure, in case of the substrate structure 100, if a spaced distance becomes 1.7 cm, it results in an antenna structure having a 1/16 wavelength of 28 cm. If the spaced distance 10 is a prescribed magnification of a wavelength, the substrate structure 100 becomes an antenna structure that radiates a frequency corresponding to the wavelength, whereby a size of electromagnetic energy is maximized. Here, the prescribed magnification may be 1/16. Hence, the present disclosure is characterized in adjusting the spaced distance to avoid 1.7 cm.

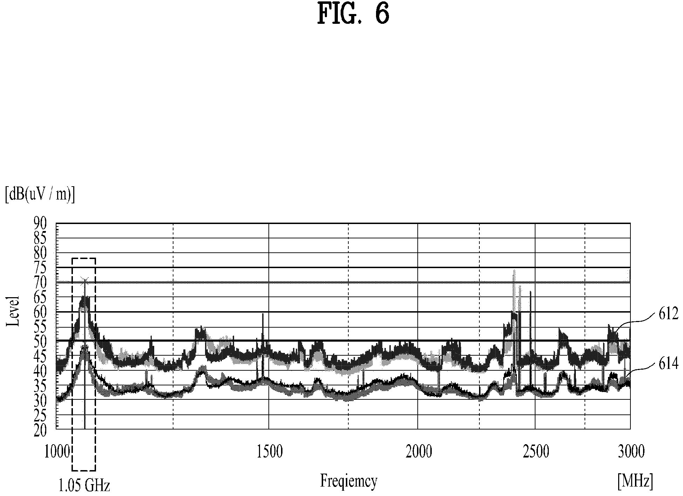

FIG. 6 is a diagram showing an example before improving electromagnetic interference according to one embodiment of the present disclosure.

FIG. 6 means a graph before improving electromagnetic interference. Referring to FIG. 6, an x-axis means a frequency section and a y-axis means a gain of an electromagnetic wave. Here, a unit of the gain is decibel.

An upper graph 612 means a peak of an electromagnetic wave and a lower graph 614 means an average of the electromagnetic wave.

When a frequency of an electronic device is 1.05 GHz and a substrate structure 100 has a slot antenna, if a spaced distance between a first SMD gasket and a second SMD gasket becomes a prescribed magnification of a wavelength corresponding to 1.05 GHz, a size of energy of an electromagnetic wave is maximized. Here, the prescribed magnification may include 1/16. For example, the frequency of the electronic device may become a DDR clock frequency. Namely, if the spaced distance becomes 1/16 of the wavelength, the size of the electromagnetic wave energy is maximized. If the spaced distance gets longer than 1/16 of the wavelength, the size of the electromagnetic wave energy is decreased.

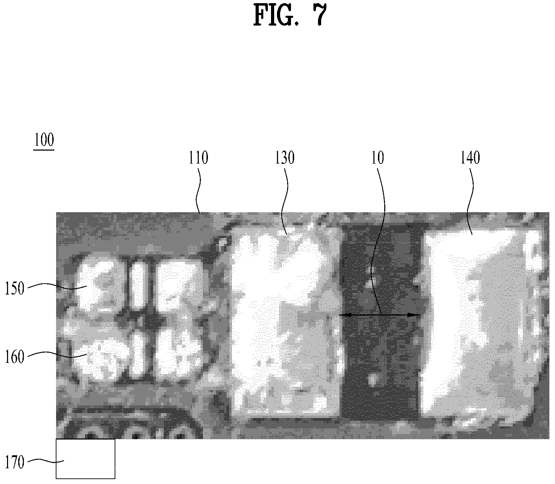

FIG. 7 is a diagram showing an SMD gasket land according to one embodiment of the present disclosure.

Referring to FIG., 7, a diagram of inserting an SMD gasket and a passive device in a substrate is described.

A first SMD gasket 130 and a second SMD gasket 140 are inserted in a substrate 110. In this case, a spaced distance 10 between the first SMD gasket 130 and the second SMD gasket 140 is designed to be different from a prescribed multiple of a wavelength corresponding to a frequency generated from another electronic device 170 inserted in the substrate. According to one embodiment of the present disclosure, the spaced distance 10 may be longer than 1/16 length of the wavelength.

In order to decrease a size of electromagnetic energy within a substrate structure 100, a first SMD gasket 150 and a second SMD gasket 160 are connected to the substrate 110 in a manner of being grounded. At least one passive device is inserted between the first and second SMD gaskets 150 and 160.

For example, a first passive device 150 and a second passive device 160 are inserted in the substrate 110. In this case, the first passive device 150 and the second passive device 160 reduce the impedance of an electromagnetic wave corresponding to the frequency generated from the electronic device 170. If a size of the impedance of the electromagnetic wave is reduced, electromagnetic interference decreases.

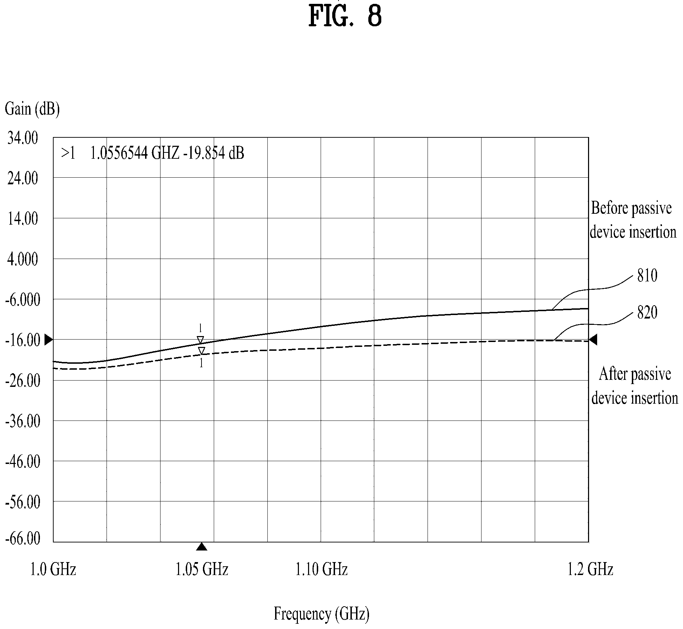

FIG. 8 is a diagram showing a gain reduction effect before and after inserting a passive device according to one embodiment of the present disclosure.

Referring to FIG. 8, an x-axis means a frequency and a y-axis means a gain. A unit of the gain is decibel. An upper line 810 means a gain graph before inserting a passive device and a lower line 820 means a gain graph after inserting the passive device.

When a frequency is 1.05 GHz, a gain before the passive device insertion is -16.8 dB and a gain after the passive device insertion is -19.8 dB.

Hence, after the passive device has been inserted, the gain is decreased by -3 dB. Here, if the gain is decreased by -3 dB, it means that energy of an electromagnetic wave is decreased to 50% from 100%, i.e., by 50%.

Particularly, as an impedance value is increased by a resistor component in the passive device, when a frequency has a value of 1.05 GHz, it brings an attenuation effect.

Namely, owing to the frequency characteristics of an indictor and capacitor of the passive device, if a frequency becomes a high frequency, it brings a more effect. Here, the high frequency means a frequency over 1 GHz. Particularly, when a frequency is a high frequency, the inductor suppresses a pass of a high frequency signal and the capacitor facilitates the pass of the high frequency signal.

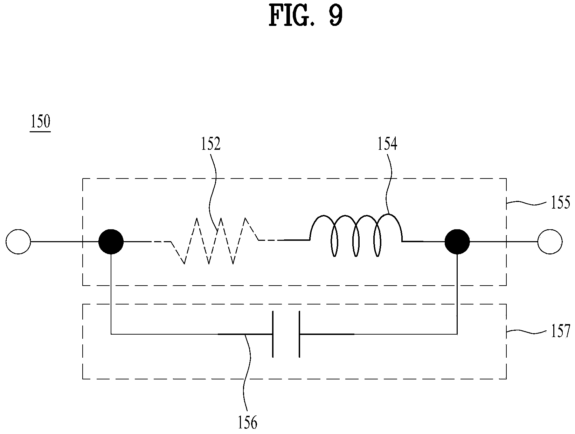

FIG. 9 is a diagram showing a structure of a passive device according to one embodiment of the present disclosure.

Referring to FIG. 9, a passive device includes a first passive device 150 and a second passive device 160.

The first passive device 150 is configured in a manner of combing a resistor 152, an inductor 154 and a capacitor together in specific order.

Particularly, the first passive device 150 is configured in a manner of configuring a first device 155 in a manner of connecting the resistor 152 and the inductor 154 in series and connecting the first device 155 and a second device 157 corresponding to the capacitor 156 in parallel with each other.

Regarding a real test according to one embodiment of the present disclosure, when the first passive device 150 is configured, the resistor 152, the inductor 154 and the capacitor 154 may be 10 Ω, 1.5 nH (nano-Henry) and 55 pF (pico-Farad), respectively.

According to the present disclosure, when a frequency generated from an electronic device is 1.05 GHz, electromagnetic energy can be reduced by inserting at least one of the first passive device 150 and the second passive device 160 between the first SMD gasket and the second SMD gasket.

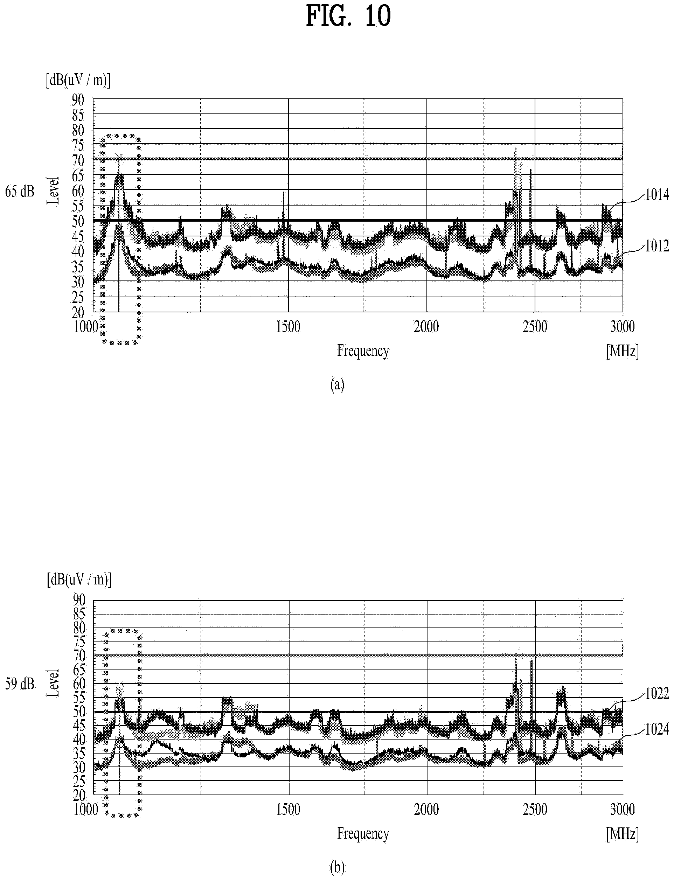

FIG. 10 is a diagram showing graphs before and after improving electromagnetic interference according to one embodiment of the present disclosure. FIG. 10 includes FIG. 10 (a) and FIG. 10 (b).

FIG. 10 (a) means a graph before improving electromagnetic interference. Referring to FIG. 10 (a), an x-axis means a frequency section and a y-axis means a gain of an electromagnetic wave. Here, a unit of the gain is decibel.

An upper graph 1012 means a peak of the electromagnetic wave and a lower graph 1014 means an average of the electromagnetic wave.

When the frequency is 1.05 GHz, a peak of the electromagnetic wave becomes 65 dB.

FIG. 10 (b) means a graph before improving electromagnetic interference. Referring to FIG. 10 (b), an x-axis means a frequency section and a y-axis means a gain of an electromagnetic wave. Here, a unit of the gain is decibel.

An upper graph 1022 means a peak of the electromagnetic wave and a lower graph 1024 means an average of the electromagnetic wave.

When the frequency is 1.05 GHz, in case that only the first passive device is inserted between the first SMD gasket and the second SMD gasket, a peak of the electromagnetic wave become 62 dB. Namely, an effect of reduction by 3 dB is confirmed.

When the frequency is 1.05 GHz, in case that only the first passive device and the second passive device are inserted between the first gasket and the second gasket, a peak of the electromagnetic wave become 59 dB. Namely, an effect of reduction by 6 dB is confirmed.

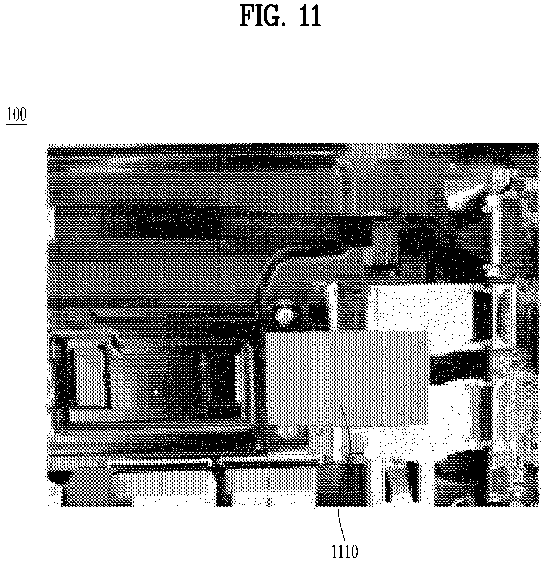

FIG. 11 is a diagram showing that an anti-electromagnetic interference tape is added to a substrate structure according to one embodiment of the present disclosure.

Referring to FIG. 11, according to a related art, an anti-electromagnetic interference tape 1110 is attached between the first SMD gasket and
the second SMD gasket of the substrate structure 100. The anti-electromagnetic interference tape 1110 prevents electromagnetic interference from occurring in the substrate structure 100. For example, a product cost of the anti-electromagnetic interference tape amounts to 42.3 Won per each.

According to the present disclosure, since it is unnecessary to attach the anti-electromagnetic interference tape 1110 additionally, a cost can be saved.

In the present disclosure, first of all, when a frequency generated from the electronic device 170 is a specific frequency, the substrate structure 100 may have a slot antenna shape. Hence, a spaced distance between the first SMD gasket and the second SMD gasket, which plays a role as an antenna of the frequency, is adjusted so as not to be an integer multiple of a wavelength corresponding to the specific frequency. If the spaced distance becomes longer than a prescribed distance, a size of impedance increase more, whereby an electromagnetic interference effect can be reduced. Here, the prescribed distance means a specific magnification of the wavelength.

Subsequently, the first SMD gasket and the second SMD gasket are grounded to the substrate.

Then, by inserting the passive device between the first SMD gasket and the second SMD gasket, electromagnetic interference can be cut off by the resistor component of the passive device.

According to one embodiment of the present disclosure, when a frequency generated from an electronic device is a specific frequency, electromagnetic interference may be cut off by setting a spaced distance between a first SMD gasket and a second SMD gasket to be different from a prescribed magnification of a wavelength corresponding to the specific frequency, thereby cutting off the electromagnetic interference without additionally reinforcing a shielding structure and also enhancing user convenience owing to cost reduction.

According to another embodiment of the present disclosure, when a frequency generated from an electronic device is a specific frequency, electromagnetic interference may be cut off by inserting a passive device between a first SMD gasket and a second SMD gasket, thereby cutting off the electromagnetic interference without additionally reinforcing a shielding structure and also enhancing user convenience owing to cost reduction.

A substrate structure and operating method thereof according to the present disclosure may be configured in a manner of selectively combining the respective embodiments entirely or in part so that various modifications can be achieved, instead of limitedly applying the configurations and methods of the above-described embodiments.

While the present disclosure has been described and illustrated herein with reference to the preferred embodiments thereof, it will be apparent to those skilled in the art that various modifications and variations can be made therein without departing from the spirit and scope of the disclosure. Thus, it is intended that the present disclosure covers the modifications and variations of this disclosure that come within the scope of the appended claims and their equivalents. In addition, such modifications and variations should not be understood individually from the technical idea or perspective of the present disclosure.

### MODE FOR DISCLOSURE

Various embodiments are described in 'BEST MODE FOR DISCLOSURE' for implementing the present disclosure.

### INDUSTRIAL APPLICABILITY

The present disclosure is used for the related fields of a substrate structure that improves electromagnetic interference caused by a signal having high frequency characteristics in a manner of adjusting a distance between SMD gaskets.

It will be appreciated by those skilled in the art that various modifications and variations can be made in the present disclosure without departing from the spirit or scope of the disclosures. Thus, it is intended that the present disclosure covers the modifications and variations of this disclosure provided they come within the scope of the appended claims and their equivalents.

## Claims

1. A substrate structure, comprising:
a substrate including at least one electronic device;
a first SMD gasket configured to remove an electromagnetic wave formed on the substrate and radiated from the substrate;
a second SMD gasket configured to remove an electromagnetic wave formed on the substrate and radiated from the substrate; and
a cover shield installed on a surface confronting the substrate to externally discharge heat within the installed region,
wherein when a frequency generated from the electronic device is a specific frequency, a spaced distance between the first SMD gasket and the second SMD gasket is set to a length different from a prescribed magnification of a wavelength corresponding to the specific frequency.

2. The substrate structure of claim 1, wherein the spaced distance is determined based on the wavelength corresponding to the specific frequency.

3. The substrate structure of claim 1, wherein the first SMD gasket and the second SMD gasket are connected to the substrate in grounded state.

4. The substrate structure of claim 1, wherein at least one passive device is formed in a manner of being inserted between the first SMD gasket and the second SMD gasket.

5. The substrate structure of claim 4, wherein the passive device is configured by combining a resistor, indictor and capacitor in specific order.

6. The substrate structure of claim 5, wherein the passive device is configured in a manner of configuring a first device by connecting the resistor and the inductor together in series and connecting the first device and a second device corresponding to the capacitor in parallel with each other.

7. A method of controlling a substrate structure, the method comprising:
removing an electromagnetic wave formed on the substrate and radiated from the substrate through a first SMD gasket;
removing an electromagnetic wave formed on the substrate and radiated from the substrate through a second SMD gasket;
externally discharging heat within a region in which a cover shield is installed on a surface confronting the substrate; and
when a frequency generated from the electronic device is a specific frequency, setting a spaced distance between the first SMD gasket and the second SMD gasket to a length different from a prescribed magnification of a wavelength corresponding to the specific frequency.
